# EUROPEAN PATENT APPLICATION

(11) **EP 4 668 583 A1**
(43) Date of publication of application: **24.12.2025**
(21) Application number: 25183939.5
(22) Date of filing: 19.06.2025
(51) Int. Cl.: H03K 17/10, H03K 17/687

(54) **A BIDIRECTIONAL SWITCHING ASSEMBLY**

(30) Priority: 20.06.2024 GB 202408848
(71) Applicant: Rolls-Royce Deutschland Ltd & Co KG, 15827 Blankenfelde-Mahlow (DE)
(72) Inventor: GAJANAYAKE, Chandana, 15827 Blankenfelde-Mahlow (DE); VALAPPIL, Muneer, 15827 Blankenfelde-Mahlow (DE); MOHAMED HALICK, Mohamed Sathik, 15827 Blankenfelde-Mahlow (DE)

(57) **Abstract**

The invention regards a bidirectional switching assembly (100) which comprises: a first switching unit (S1) which comprises a first low voltage MOSFET (T1), wherein the first low voltage MOSFET (T1) comprises a first gate (G1), a second switching unit (S2) which comprises a second low voltage MOSFET (T2), wherein the second low voltage MOSFET (T2) comprises a second gate (G2), and a third switching unit (S3) which comprises a normally ON high voltage semiconductor switch (T3, T31, T32), wherein the normally ON high voltage semiconductor switch (T3, T31, T32) comprises a third gate (G3, G31, G32) and wherein the third gate (G3, G31, G32) is connected through high-voltage diodes (D1, D2) with an input side (IN) and with an output side (OUT) of the switching assembly (100). The first switching unit (S1), the third switching unit (S3) and the second switching unit (S2) are arranged in series, with the third switching unit (S3) sandwiched between the first switching unit (S1) and the second switching unit (S2), wherein in one direction the third switching unit (S3) and the second switching unit (S2) form a cascode and in the other direction the third switching unit (S3) and the first switching unit (S1) form a cascode. The switching assembly (100) is configured to conduct a current in either direction when the third switching unit (S3) is switched on and configured to block a current in either direction when the third switching unit (S3) is switched off, wherein the third switching unit (S3) is switched on and off by switching on and off at least one of the first and second switching units (S1, S2).

## Description

### FIELD OF THE DISCLOSURE

The present disclosure relates a bidirectional switching assembly that may be implemented in power systems for aircrafts or other vehicles.

### BACKGROUND

With increased penetration of electrical systems and the progression towards full electric and hybrid propulsion systems, the use of energy storage systems and DC power distribution has gained increased use. Multiple loads and sources may be connected to a DC distribution system such as a hybrid propulsion system. In such systems, power converters such as inverters, rectifiers and DC/DC converters are needed for interfacing electrical propulsion motors, turbo generators, fuel cells and battery energy storage systems. Further, in such systems, adequate DC protection devices are required. Due to the fact that SSPCs (Solid State Power Controllers, also referred to a Solid State Circuit Breakers) show a fast response time, eliminate arcing during turn-off, and have a high reliability, SSPCs are preferred over electro-mechanical switches.

SSPCs may be implemented using bidirectional switching units that allow a bidirectional control of the current flow between a power source and a load. Bidirectional switching units are conventionally formed by two MOSFET or IGBT devices in common source/collector or common drain/emitter configuration. While allowing bidirectional conducting and blocking, such bidirectional switching units are associated with the disadvantages of high voltage drop, high power loss and large footprint requirements.

There is a need to provide a bidirectional switching assembly that can be implemented in an effective manner with low power losses and/or be used in other power components such as power converters and battery chargers, or at least provide a useful alternative to known bidirectional switching assemblies. It is also useful to provide power electronics devices in which such bidirectional switching assemblies can be implemented efficiently.

### SUMMARY OF THE DISCLOSURE

According to an aspect of the invention, a bidirectional switching assembly is provided. The bidirectional switching unit comprises a first switching unit, a second switching unit and a third switching unit. The first switching unit comprises a first low voltage MOSFET, wherein the first low voltage MOSFET comprises a first gate. The second switching unit comprises a second low voltage MOSFET, wherein the second low voltage MOSFET comprises a second gate. The third switching unit comprises a normally ON high voltage semiconductor switch (such as a JFET or HEMT), wherein the normally ON high voltage semiconductor switch comprises a third gate, and wherein the third gate is connected through high-voltage diodes with an input side and with an output side of the switching assembly.

It is further provided that the first switching unit, the third switching unit and the second switching unit are arranged in series, with the third switching unit sandwiched between the first switching unit and the second switching unit, wherein in one direction the third switching unit and the second switching unit form a cascode and in the other direction the third switching unit and the first switching unit form a cascode. The switching assembly is configured to conduct a current in either direction when the third switching unit is switched on and is configured to block a current in either direction when the third switching unit is switched off, wherein the third switching unit is switched on and off by switching on and off at least one of the first and second switching units.

Aspects of the invention are thus based on the idea to provide for a bidirectional switching assembly which comprises one normally ON high-voltage switch only, wherein the high-voltage switch is sandwiched between two low-voltage MOSFET switches of the first and second switching units. The normally ON high-voltage switch has a bidirectional high-voltage blocking capability. The switching status of the MOSFET switches determines - through the high-voltage diodes - whether the normally ON high-voltage switch is switched off or on, thereby blocking or not blocking the bidirectional switching assembly. This allows the bidirectional switching assembly to be controlled through the MOSFET switches of the first and second switching unit.

Aspects of the invention provide for a bidirectional conducting and bidirectional blocking capable switching assembly with smaller footprint, lower loss, lower weight, and higher efficiency. Compared to two high voltage MOSFETs, normally ON high-voltage switches such as JFETs have lower ON state resistance and lower thermal impedance. Normally ON high-voltage switches can dissipate larger power losses without reaching a maximum junction temperature.

A further advantage associated with the present invention lies in that low voltage MOSFETs are cheap such that the combination of two MOSFET and one normally ON high-voltage switch is highly competitive in terms of costs and material use. These qualities can help the spreading of SSPC applications and of other applications that require bidirectional switching such as in electro vehicle charging circuits, matrix converter, T type converters and multiple other power converters which require/use bidirectional switches.

The proposed switching topology can have a normally OFF status when there are no gate signals applied to the MOSFETs, wherein positive or negative high voltages applied across the switching assembly are blocked by the normally ON high-voltage switch. When the MOSFETs are switched ON by applying corresponding gate signals, the switching assembly conducts current in both directions.

The switching assembly of the present invention is bidirectional which means that it allows to control the current flow through the switching assembly in two directions. More particularly, the switching assembly of the present invention is a four-quadrant switch as it can conduct current in both directions and block voltage in both directions.

According to some embodiments, the high-voltage diodes comprise a first high-voltage diode connected at one terminal to the gate of the normally ON high voltage semiconductor switch and connected at the other terminal to the input side of the first switching unit. The high-voltage diodes further comprise a second high-voltage diode connected at one terminal to the gate of the normally ON high voltage semiconductor switch and connected at the output side of the second switching unit. The first and second high-voltage diodes serve to block the gate of the normally ON high voltage semiconductor switch from the high voltage present at the input and the output of the switching assembly. They are not carrying large currents and are only used for blocking voltage.

In this respect, it is pointed out that the bidirectional switching assembly of the present invention is suitable for conducting and blocking high voltages, in particular voltages above 100V, in particular voltages at or above 1000 V.

In some embodiments, the first switching unit and the second switching unit each comprise an antiparallel diode arranged antiparallel to the first low voltage MOSFET and the second low voltage MOSFET, respectively. Accordingly, each of the first and second switching units comprise an antiparallel diode. Such antiparallel diode allows to pass current through the switching unit when the MOSFET of the switching unit is blocking. For example, when the third switching unit and the second switching unit are switched on to conduct a current in one direction, the first switching unit may be switched off. In such case, the antiparallel diode makes sure that the current flowing through the third switching unit and the second switching unit also passes through the first switching unit to allow a current path through the switching assembly. In other embodiments, the MOSFET of the first switching unit is also switched on in such case.

In some embodiments, the first switching unit and the second switching unit additionally each comprise a bidirectional transient voltage suppressor (TVS) diode arranged in parallel to the first low voltage MOSFET and the second low voltage MOSFET, respectively. A TVS diode serves as protection from transient voltage spikes.

In some embodiments, the first low voltage MOSFET and the second low voltage MOSFET are controlled with the same logic signal. Accordingly, they are switched on and off simultaneously in such embodiment. Alternatively, the first low-voltage MOSFET and the second low-voltage MOSFET are controlled by independent logical signals. In either embodiment, control of the MOSFETs may be provided by a controller which controls a gate driver of the MOSFETs, wherein such controller may be integrated into the gate driver or be a separate controlling unit.

In some embodiments, the first low voltage MOSFET and the second low voltage MOSFET are driven by independent (and isolated) gate drivers, wherein the independent gate drivers may provide the same or different logical signals to the gate of the respective MOSFET. Providing independent gate drivers is associated with the advantage that the first and second low-voltage MOSFETs can be controlled independently. Also, the independent gate drivers may be powered independently. In other embodiments, the first low-voltage MOSFET and the second low-voltage MOSFET are controlled by the same gate driver.

In a further embodiment, the switching assembly is configured to conduct a current in the one direction when at least the third switching unit and the second switching unit are switched on and is further configured to conduct a current in the other direction when at least the third switching unit and the first switching unit are switched on. This is associated with the feature that in one direction the third switching unit and the second switching unit form a cascode and in the other direction the third switching unit and the first switching unit form a cascode. In this respect, it is pointed out that a cascode within the meaning of the present disclosure is any sequence of semiconductor switches in which the source/drain output of one semiconductor switch is connected to the source/drain input of the other semiconductor switch.

In some embodiments, the first low voltage MOSFET and a second low voltage MOSFET are in OFF state when there are no gate signals applied by the first and second gate drivers. Accordingly, in such case, an ON signal has a to be applied to the gates by the respective gate drivers for the MOSFETs to become conductive. When the MOSFETs are in the OFF state, the normally ON high-voltage switch is also switched off, thereby blocking high voltages in both directions.

It is generally pointed out that both the first low-voltage MOSFET and the second low-voltage MOSFET may comprise a plurality of low-voltage MOSFETs which are arranged in parallel. This allows to increase the current capacity and/or to reduce the voltage drop and power loss. In a similar manner, it may be provided that, in embodiments, the normally ON high-voltage switch comprises a plurality of such switches arranged in parallel.

It is further pointed out that the high-voltage diodes which shield the gate of the normally ON high-voltage switch may be comprised of one or several diodes arranged in series. When several diodes are arranged in series, the forward voltage is increased and the reverse blocking capabilities are enhanced.

In a further embodiment, the first low voltage MOSFET and the second low voltage MOSFET are configured to have a maximum drain-to-source voltage of 40 Volts and to have a maximum current through the drain-source channel of 500 Ampere. It may be further provided that, at the same time, the resistance of the drain-source channel in the ON state is in the range of 0.5 mΩ (milliohm).

On the other hand, in embodiments, the normally ON high-voltage switch may have a maximum drain-to-source voltage of 1200 or 2400 Volts and a maximum current through the drain-source channel of 120 Amperes. It may be further provided that, at the same time, the resistance of the drain-source channel in the ON state is in the range of 9 mΩ (milliohm).

In a further embodiment, the normally ON high voltage semiconductor switch comprises a dual gate configuration with a first third gate and a second third gate, wherein the first third gate is connected through a high-voltage diode with the input side of the switching assembly and the second third gate is connected through a high-voltage diode with the output side of the switching assembly. Such embodiment is based on a semiconductor switch topology in which the semiconductor switch comprises two gates, wherein the two gates are used for blocking in both directions. More particularly, each high-voltage diode is connected to one of the dual gates, shielding the respective gate against high voltage. A dual gate configuration increases the blocking capability of the normally ON high-voltage switch in both directions. Also, the circuit complexity of a circuit which implements the bidirectional switching assembly may be reduced and become simpler.

In a still further embodiment, the third semiconductor switch comprises first and second normally ON high voltage semiconductor switches arranged in series and both sandwiched between the first and second semiconductor switches, wherein the gates of the first and second normally ON high voltage semiconductor switches are each connected through high-voltage diodes with an input side and with an output side of the switching assembly. This embodiment allows to increase the blocking voltage by connecting two or more of the normally ON high-voltage semiconductor switches in series. Accordingly, a switching assembly with higher voltage levels, i.e., that is robust for higher voltage levels is provided for by connecting several of the normally ON high-voltage switches in series. A scalable bidirectional semiconductor switch is provided for.

In a variant of such embodiment, the assembly further comprises a balancing circuit for balancing the voltage across the first and second normally ON high voltage semiconductor switches, wherein the balancing circuit comprises two avalanche diodes, which may be connected back to back in embodiments, the avalanche diodes connecting the gates of the first and second normally ON high voltage semiconductor switches.

Such balancing circuit serves to allow bidirectional conducting and bidirectional blocking of the switching assembly, and allows for equal sharing of the blocking voltage between the two normally ON high-voltage switches. The two back to back avalanche diodes provide the function that when one of the avalanche diodes is conducting the other one is blocking based on the current directions.

In a further embodiment, the balancing circuit further comprises a low-voltage diode having a terminal connected to a point between the first and third semiconductor switches and a terminal connected to the gate of the first normally ON high voltage semiconductor switch, and a low-voltage diode having a terminal connected to a point between the third and second semiconductor switches and a terminal connected to the gate of the second normally ON high voltage semiconductor switch. Further, the balancing circuit may comprise resistors which are used to set the desired voltages, wherein the resistors are arranged outside of the current conduction path through the switching assembly.

In a further embodiment, the normally ON high voltage semiconductor switch comprises a drift region arranged between a source terminal and a drain terminal of the semiconductor switch, wherein the gate terminal is arranged in the middle of the drift region, at even space to the source terminal and the drain terminal. The background of this embodiment lies in that conventional normally ON high voltage semiconductor switches such as a JFETs struggle to fully block voltage in both directions, especially in high-voltage applications. In particular, in high-voltage JFETs, the reverse blocking voltage V_{DS} is lower than the forward blocking voltage V_{SD} due to the proximity of the gate terminal to the source. To address this problem, the embodiment shifts the gate terminal to the middle of the structure.

In a variant of that embodiment, the normally ON high voltage semiconductor switch comprises two gate terminals, wherein the first and second gate terminals are arranged symmetrically with respect to the source terminal and the drain terminal.

In embodiments, the normally ON high voltage semiconductor switch is a JFET ("junction field-effect transistor") or HEMT ("high-electron-mobility transistor") semiconductor switch. In particular, it may be a SiC JFET or GaN HEMT semiconductor switch. Both are bidirectional switches which are able to block or conduct currents in both directions and which are ON when there is no gate signal applied.

The use of a bidirectional semiconductor assembly which is in accordance with the present invention is generally not limited and may occurs in all circuits which require bidirectional switching. In embodiments, the switching assembly of the present invention is an element of a solid state power controller, a matrix converter, a T-Type converter, a Vienna rectifier, or a battery charging circuit, wherein these implementations are to be understood as examples only.

Accordingly, in a further aspect of the invention, a power system is provided, wherein the power system comprises a power bus having a positive voltage rail and a negative voltage rail and configured to connect a power source with a load, and a bidirectional solid state power controller arranged in at least one of the positive voltage rail and the negative voltage rail. It is provided that the bidirectional solid state power controller comprises a bidirectional switching assembly in accordance with the present invention. This aspect of the invention thus implements a bidirectional switching assembly which is accordance with the present invention in a solid state power controller.

In some embodiments, the power system further comprises a controller, wherein the controller is configured to receive information or determine that there is a fault (somewhere in the system), wherein, in such case, the controller is further configured to control the first and second switching units such that these are switched off. By the first and second switching units being switched off (namely, by the respective MOSFETs being switched off), the normally ON high-voltage switch is switched off as well and blocks a high-voltage on the voltage rail. Thereby, the bidirectional switching assembly blocks the conduction of current on the voltage rail.

In a still further aspect of the invention, a matrix converter is provided which implements bidirectional switching assemblies which are in accordance with the present invention. More particularly, the matrix converter comprises an AC input side, an AC output side, and an array of bidirectional switching assemblies which are in accordance with the invention and arranged between the AC input side and the AC output side. Generally, a matrix converter comprises a plurality of bidirectional power switches that directly connect an AC voltage source to a load. Unlike traditional converters that use a DC link (such as with rectifiers and inverters), a matrix converter achieves power conversion without any intermediate energy storage.

The skilled person will appreciate that except where mutually exclusive, a feature or parameter described in relation to any one of the above aspects may be applied to any other aspect. Furthermore, except where mutually exclusive, any feature or parameter described herein may be applied to any aspect and/or combined with any other feature or parameter described herein.

### BRIEF DESCRIPTION OF THE DISCLOSURE

The invention will be explained in more detail on the basis of exemplary embodiments with reference to the accompanying drawings in which:
FIG. 1 is an embodiment of a bidirectional switching assembly which comprises first and second switching units and a third switching unit sandwiched between the first and second switching units, wherein the first and second switching units each comprise a low-voltage MOSFET and wherein the third switching unit comprises a normally ON high-voltage semiconductor switch which is controlled by the low-voltage MOSFETs;
FIG. 1A is a schematic depiction of the bidirectional switching assembly of FIG. 1;
FIG. 2A depicts the bidirectional switching assembly of FIG. 1 when conducting current in a forward direction;
FIG. 2B depicts the bidirectional switching assembly of FIG. 1 when blocking current in a forward direction;
FIG. 2C depicts the bidirectional switching assembly of FIG. 1 when conducting current in a backward direction;
FIG. 2D depicts the bidirectional switching assembly of FIG. 1 when blocking current in a backward direction;
FIG. 3 is a variant of the bidirectional switching assembly of FIG. 1 which additionally comprises transient voltage suppressors for over protection;
FIG. 4 is a further variant of the bidirectional switching assembly of FIG. 1 in which the normally ON high-voltage semiconductor switch comprises a dual gate configuration;
FIG. 5A is a further embodiment of a bidirectional switching assembly which comprises first and second switching units and a third switching unit sandwiched between the first and second switching units, wherein the first and second switching units each comprise a low-voltage MOSFET and wherein the third switching unit comprises first and second normally ON high-voltage semiconductor switches which are connected in series and controlled by the low-voltage MOSFETs;
FIG. 5B is a variant of the bidirectional switching assembly of FIG. 5A in which a slew rate control is additionally integrated;
FIG. 6A depicts the bidirectional switching assembly of FIG. 5A when conducting current in a forward direction;
FIG. 6B depicts the bidirectional switching assembly of FIG. 5A when blocking current in a forward direction;
FIG. 6C depicts the bidirectional switching assembly of FIG. 5A when conducting current in a backward direction;
FIG. 6D depicts the bidirectional switching assembly of FIG. 5A when blocking current in a backward direction;
FIG. 7 is a variant of the bidirectional switching assembly of FIG. 5B which additionally comprises transient voltage suppressors for over protection;
FIG. 8 is a further variant of the bidirectional switching assembly of FIG. 5B in which a common drain configuration of the normally ON high-voltage semiconductor switches is implemented;
FIG. 9 is a further variant of the bidirectional switching assembly of FIG. 5B in which the first and second normally ON high-voltage semiconductor switches comprise a dual gate configuration;
FIG. 10 is a further embodiment of a bidirectional switching assembly which comprises first and second switching units and a third switching unit sandwiched between the first and second switching units, wherein the first and second switching units each comprise a low-voltage MOSFET and wherein the third switching unit comprises four normally ON high-voltage semiconductor switches which are connected in series and controlled by the low-voltage MOSFETs;
FIGS. 11A-11E show different embodiments of a JFET semiconductor switch with different positions of the JFET gate with respect to the JFET source and the JFET drain;
FIG. 12 is a power system which comprises a power bus with a positive voltage rail and a negative voltage and a bidirectional solid state power controller, wherein the bidirectional solid state power controller comprises a bidirectional switching assembly in accordance with FIG. 1 in the positive voltage rail;
FIG. 13 is a power system similar to the power system of FIG. 12, wherein a bidirectional switching assembly in accordance with FIG. 4 is arranged in the positive voltage rail;
FIG. 14 is a power system similar to the power system of FIG. 12, wherein a bidirectional switching assembly in accordance with FIG. 1 is arranged both in the positive voltage rail and the negative voltage rail;
FIG. 15 is a power system similar to the power system of FIG. 12, wherein a bidirectional switching assembly in accordance with FIG. 4 is arranged both in the positive voltage rail and the negative voltage rail;
FIG. 16 is a power system similar to the power system of FIG. 12, wherein a bidirectional switching assembly in accordance with FIG. 5B is arranged in the positive voltage rail;
FIG. 17 is a power system similar to the power system of FIG. 12, wherein a bidirectional switching assembly in accordance with FIG. 9 is arranged in the positive voltage rail;
FIG. 18 is a power system similar to the power system of FIG. 12, wherein a bidirectional switching assembly in accordance with FIG. 5B is arranged both in the positive voltage rail and the negative voltage rail;
FIG. 19 is a power system similar to the power system of FIG. 12, wherein a bidirectional switching assembly in accordance with FIG. 9 is arranged both in the positive voltage rail and the negative voltage rail;
FIG. 20 is an embodiment of a matrix converter that implements bidirectional switching assemblies;
FIG. 21 is an embodiment of a T-type converter that implements bidirectional switching assemblies;
FIG. 22 is an embodiment of a Vienna rectifier that implements bidirectional switching assemblies;
FIG. 23 is an embodiment of a three phase single stage charging topology with a battery that implements bidirectional switching assemblies;
FIG. 24 is an embodiment of a three phase single stage charging topology with a DC load that implements bidirectional switching assemblies;
FIG. 25 is an embodiment of an isolated single phase charging circuit for EV applications that implements bidirectional switching assemblies;
FIG. 26 is an embodiment of an isolated three phase charging circuit for EV applications that implements bidirectional switching assemblies;
FIG. 27 is an embodiment of an isolated charging circuit for EV applications with LC resonance that implements bidirectional switching assemblies; and
FIG. 28 shows a DC power distribution and protection system that implements a solid state power controller with bidirectional switching assemblies not in accordance with the present invention.

### DETAILED DESCRIPTION

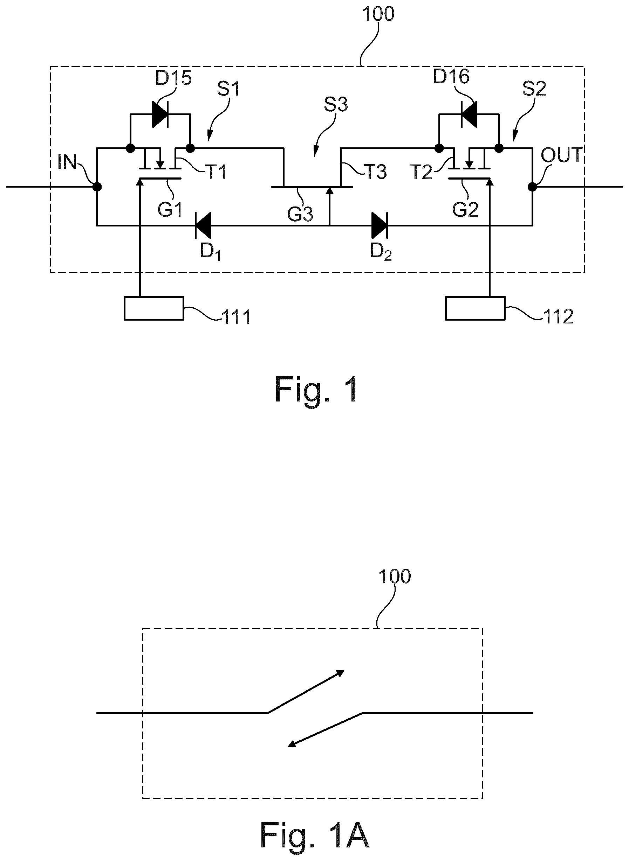

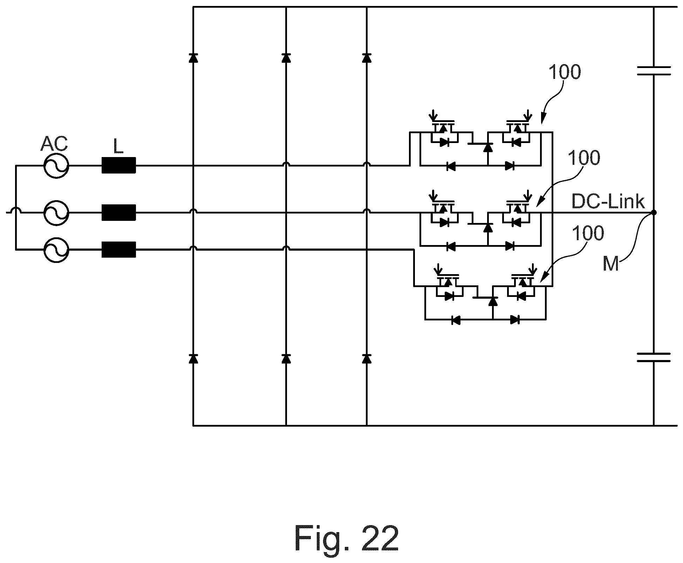

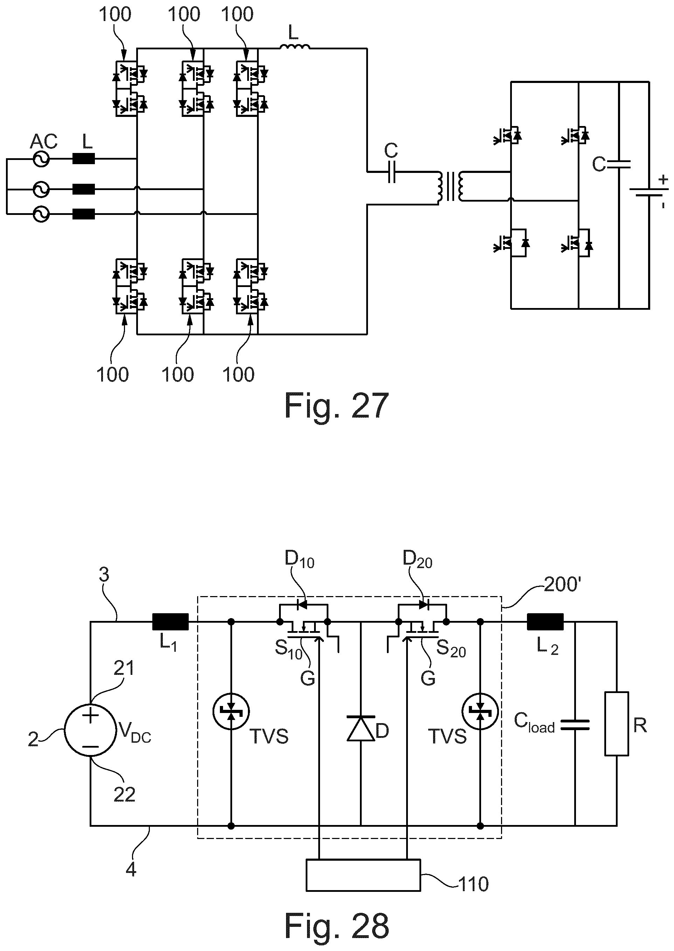

Before discussing embodiments of the present invention with respect to FIGS. 1 to 27, the background of the invention is discussed with respect to FIG. 28 to provide for a better understanding of the present invention.

FIG. 28 shows a DC power distribution and protection system that comprises a solid state power controller 200', in the following referred to as SSPC. The system comprises a DC power source 2 (such as a DC battery) that has a positive terminal 21 and a negative terminal 22. Between the positive terminal 21 and the negative terminal 22 a voltage V_{DC} is present. A positive voltage rail 3 is connected to the positive terminal 21 and a negative voltage rail 4 is connected to the negative terminal 22. The positive voltage rail 3 and the negative voltage rail 4 form a high-voltage bus.

The system further comprises a load R, wherein the load R may be formed in a plurality of manners. In examples, the load may be a power converter such as an inverter and/or an electric motor. A capacitive load generally depicted as C_{load} is arranged in parallel to the load R and extends between the positive voltage rail 3 and the negative voltage rail 4. For example, the capacitive load C_{load} may be formed by DC link capacitors or include such capacitors.

The SSPC 200' is a bidirectional SSPC and comprises a first semiconductor switch S10 with an antiparallel bypass diode D10 and a second semiconductor switch S20 with an antiparallel bypass diode D20 both arranged in the positive voltage rail 3. As the SSPC is bidirectional, it is able to isolate the positive voltage rail 3 in both directions. In other embodiments, the SSPC 200' additionally comprises bidirectional semiconductor switches on the negative voltage rail 4, or comprises semiconductor switches on the negative voltage rail 4 only.

The switches S10, S20 may be MOSFET (metal-oxide-semiconductor field-effect transistor), GaN (Gallium Nitride), SiC (Silicon Carbide) or IGBT (Insulated Gate Bipolar Transistor) switches. A further diode D may extend between the positive voltage rail 3 and the negative voltage rail 4. Further, optionally, a transient voltage suppressor diodes TVS may extend between the positive voltage rail 3 and the negative voltage rail 4.

The SSPC 200' further comprises a gate driver 110 that is responsible for controlling the switching of the semiconductor switches S10, S20 and provides the necessary gate signals to the control terminals, i.e., the gates G of semiconductor switches S10, S20. The SSPC 200' may also comprise a microcontroller (not shown) for control of the logic and for generating a pulsed signal for the gate driver 110.

In FIG. 28, the semiconductor switches S10, S20 with antiparallel diodes D10, D20 are connected in common source/emitter configuration. The antiparallel diodes D10, D20 give current that flows in the opposite direction a path to flow. The system further comprises two inductances L1, L2, one before switch S10 and one behind switch S20, wherein the inductances L1, L2 are configured to limit the rate of rise of current in case of a short-circuit fault.

The semiconductor switches S10, S20 are high-voltage MOSFET or IGBT switches and form a bidirectional switching assembly. One major concern of such bidirectional switching assembly are a high voltage drop, a high power loss and large footprint requirements.

FIG. 1 shows an embodiment of a bidirectional switching assembly 100 with improved performance compared to the switching assembly implemented in FIG. 28. The bidirectional switching assembly 100 comprises a first switching unit S1, a second switching unit S2 and a third switching unit S3. The first switching unit S1 comprises a first low-voltage MOSFET T1 and an antiparallel diode D15. The second switching unit S2 comprises a second low-voltage MOSFET T2 and an antiparallel diode D16. Sandwiched between the first switching unit S1 and the second switching unit S2 is the third switching unit S3, wherein the third switching unit S3 comprises a high-voltage JFET semiconductor switch T3 (e.g., SiC JFET). In another embodiment, T3 is a HEMT semiconductor switch (e.g., GaN HEMT).

The first MOSFET T1 comprises a gate G1 which is controlled by a first gate driver 111. The second MOSFET T2 comprises a gate G2 which is controlled by a second gate driver 112. The gate drivers 111, 112 may be controlled by a higher level controller. Also, in an alternative embodiment, one gate driver is used to drive both gates G1, G2. The JFET T3 comprises a gate G3 which is not controlled through a gate driver, but which is controlled through MOSFETs T1, T2. To this end, the third gate G3 is connected through a first high-voltage diode D1 with an input side IN of the bidirectional switching assembly 100. The third gate G3 is further connected through a high-voltage diode D2 with an output side OUT of the bidirectional switching assembly 100. More particularly, one terminal of diode D1 is connected the gate G3 and the other terminal of D1 is connected to the input side IN of the switching assembly. Similarly, one terminal of diode D2 is connected to gate G3 and in the other terminal of D2 is connected to the output side OUT of the switching assembly. The diodes D1, D2 are high-voltage diodes that prevent the gate G3 to connect into the rail with the source and drain terminals of switches T1, T2, T3. They do not carry large currents and are only used for blocking.

The MOSFETs T1, T2 and the JFET T3 are arranged such that in one direction (in case of current flow from left to right) the JFET T3 and the MOSFET T2 form a cascode, and that in the other direction (in case of current flow from right to left) the JFET T3 and the MOSFET T1 form a cascode. Accordingly, drain/source of the respective switches T1, T3, T2 are connected.

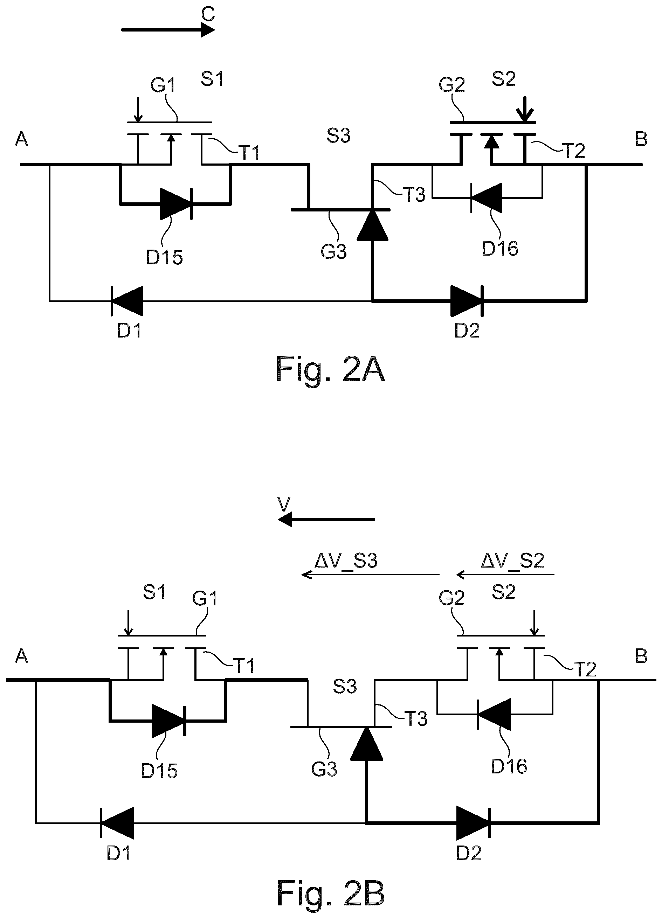

The JFET T3 represents a normally ON high-voltage semiconductor switch which means that it is able to guide a current if there is no specific voltage applied to its gate G3. On the other hand, the MOSFETs T1, T2 are normally OFF low-voltage semiconductor switches which means that they only guide current if a specific voltage is applied to its gates G1, G2 by the respective gate driver 111, 112. The depicted circuit functions such that a current can be guided in either direction when the third switching unit S3 is switched on and that a current flow is blocked in either direction when the third switching unit S3 is switched off, wherein the third switching unit S3 is switched on and off through the first and second switching units S1, S2, as will be discussed in more detail with reference to FIGS. 2A to 2D.

The switching assembly 100 may be realized monolithically or as a power module connecting discrete MOSFET, JFET and diode components in a substrate. The low Voltage MOSFETs T1, T2 are high current capable. They may be configured to have a maximum drain-to-source voltage of 40 Volts and to have a maximum 500 Ampere maximum current through the drain-source channel. The resistance of the drain-source channel in the ON state of the MOSFETs T1, T2 may be in the range of 0.5 mΩ (milliohm). The high-voltage JFET T3 may be configured to block a voltage of at least 1000 V, such as 1200 V or 2400 V.

FIG. 1A depicts a symbol representation of the bidirectional switching assembly of FIG. 1.

According to FIG. 2A, the situation is considered that a current is flowing from point A to point B. For example, point A is connected to a positive DC terminal and point B is connected to a load. If the current is flowing from A to B, the antiparallel diode D15 of the first switching unit S1 will conduct and a current will pass through JFET T3 and then through MOSFET T2 if MOSFET T2 is in ON state. To this end, a turn ON voltage from gate driver 112 of FIG. 1 is applied to the gate G2 of MOSFET T2. During this time, blocking high-voltage diode D1 will be reverse biased, while high-voltage diode D2 will be forward biased, wherein the JFET T3 conduction is based on the voltage drop across MOSFET T2.

In an embodiment, MOSFET T1 is also turned ON, wherein MOSFET T1 will also conduct current and have lower losses.

FIG. 2B shows the situation that the switching unit S2 is switched/turned off (by the gate driver 112 providing a corresponding control signal to the gate G2 of T2). In such case, the voltage drop ΔS_S2 across switching unit S2 will increase. At the same time, a positive voltage is maintained at A. Accordingly, the voltage drop across S2 will increase, thereby the gate voltage at gate G3 of JFET T3 will increase in the negative direction. This leads to JFET T3 becoming fully switched/turned off and JFET T3 starts to block the high voltage ΔV_S3, as indicated in FIG. 2B.

It is to be noted that high-voltage diode D1 in its blocking state prevents the JFET gate G3 to see a large positive voltage applied at A. This allows the JFET T3 to be put into the OFF state from both directions while protecting the JFET gate G3. Once the JFET T3 is turned OFF, the full voltage across the JFET and small voltages across the MOSFET T2 apply. The current flow is completely stopped.

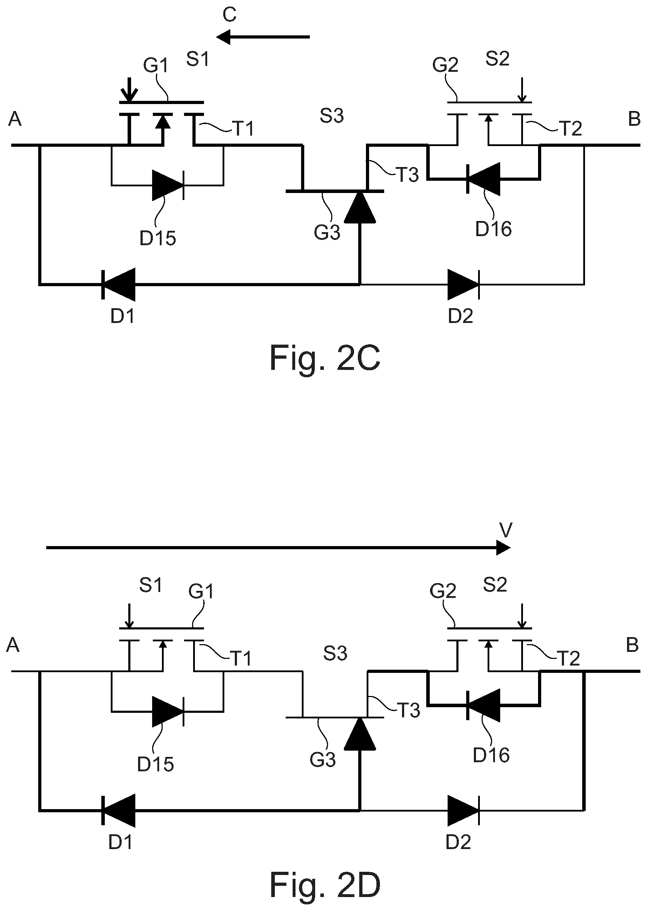

FIG. 2C considers the situation of a reverse current flow, wherein a current is flowing from point B to point A. If the current is flowing from B to A, the antiparallel diode D16 of the second switching unit S2 will conduct and a current will pass through JFET T3 and then through MOSFET T1 if MOSFET T1 is in ON state. To this end, a turn ON voltage from gate driver 111 of FIG. 1 is applied to the gate G1 of MOSFET T1. During this time, blocking high-voltage diode D2 will be reverse biased, while high-voltage diode D1 will be forward biased, wherein the JFET T3 conduction is based on the voltage drop across MOSFET T1.

In an embodiment, MOSFET T2 is also turned ON, wherein MOSFET T2 will also conduct current and have lower losses.

FIG. 2D shows the situation that the switching unit S1 is switched/turned off (by the gate driver 111 providing a corresponding control signal to the gate G1 of T1). In such case, the voltage drop across switching unit S1 will increase. At the same time, a positive voltage is maintained at B. Accordingly, the voltage drop across S1 will increase, thereby the gate voltage at gate G3 of JFET T3 (bias voltage) will increase. This leads to JFET T3 becoming fully switched/turned off and JFET T3 starts to block the high voltage.

It is to be noted that high-voltage diode D2 in its blocking state prevents the JFET gate G3 to see a large positive voltage applied at B. This allows the JFET T3 to be put into the OFF state from both directions while protecting the JFET gate G3. Once the JFET T3 is turned OFF, the full voltage across the JFET and small voltages across MOSFET T1 apply. The current flow is completely stopped.

It may be provided that both MOSFETs T1, T2 receive at their gates G1, G2 the same logic pulse irrespective of the voltage or current direction, while this is not necessarily the case. At the same time, it may be provided that both MOSFET gates G1, G2 are supplied with two different isolated power supplies as they will drive respective drains which are connected to point A or B.

Accordingly, as is clear from FIGS. 2A to 2D, JFET T3 is blocking (switched off) in one direction if MOSFET T2 (and optionally also MOSFET T1) is switched off and JFET T3 is blocking (switched off) in the other direction if MOSFET T1 (and optionally also MOSFET T2) is switched off. When both MOSFET T1 and MOSFET T2 are switched off, JFET T3 blocks current in both directions. At the same time, JFET T3 is guiding current in one direction if T2 is switched on and JFET T3 is guiding current in the other direction if T1 is switched on. For example, by switching T2 off, JFET T3 and the switching assembly 100 are changed from a state in which a current is guided through the switching assembly in one direction to a state in which current flow is blocked. Similarly, by switching T1 off, JFET T3 and the switching assembly 100 are changed from a state in which a current is guided through the switching assembly in the other direction to a state in which current flow is blocked. The switching status of T1 and/or T2 thus defines if the JFET T3 is blocking or not.

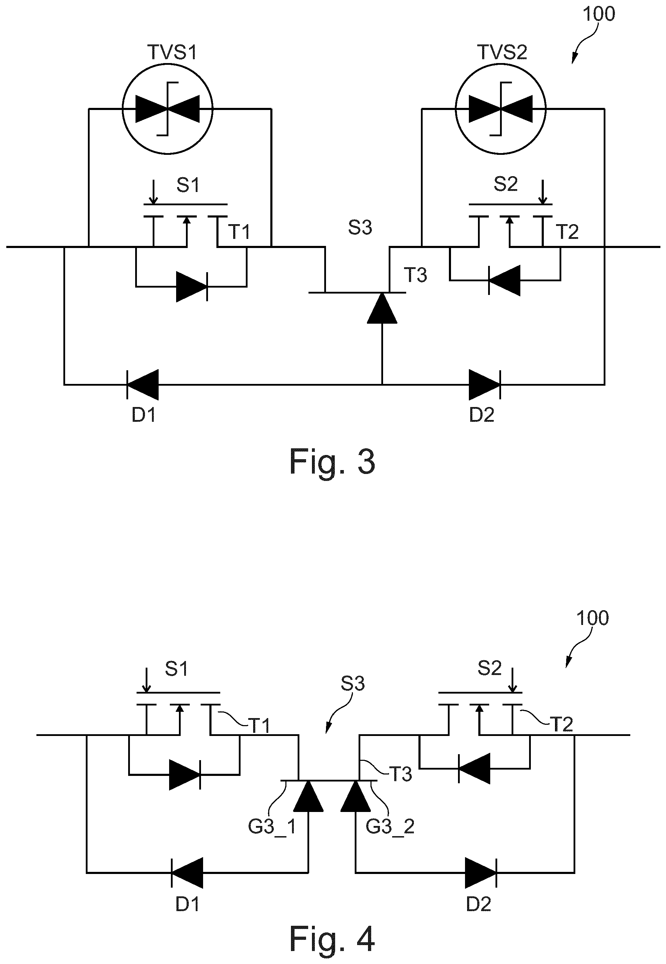

FIG. 3 shows an embodiment of a bidirectional switching assembly 100 which is similar to the switching assembly of FIG. 1 except that additionally transient voltage suppressor diodes TVS1, TVS2 are arranged in parallel to the MOSFETs T1, T2 for over voltage protection. Thereby, during the off state, the voltage across the MOSFETs T1, T2 will be low voltage (the TVS voltage) and the full blocking voltage appears across the JFET T3.

FIG. 4 shows an embodiment of a bidirectional switching assembly 100 which is similar to the switching assembly of FIG. 1 except that a JFET T3 with a dual gate a configuration is implemented. Accordingly, JFET T3 comprises a first gate G3_1 and a second gate G3_2, wherein both gates are able to control the current flow between drain and source of the JFET. In this embodiment, high-voltage diode D1 is connected with one of its terminals to the first gate D3_1 and high-voltage diode D2 is connected with one of its terminals to the second gate G3_1. The high voltage blocking diodes D1, D2 protect the respective gate voltage. Such embodiment increases the blocking capability of the switch on both directions.

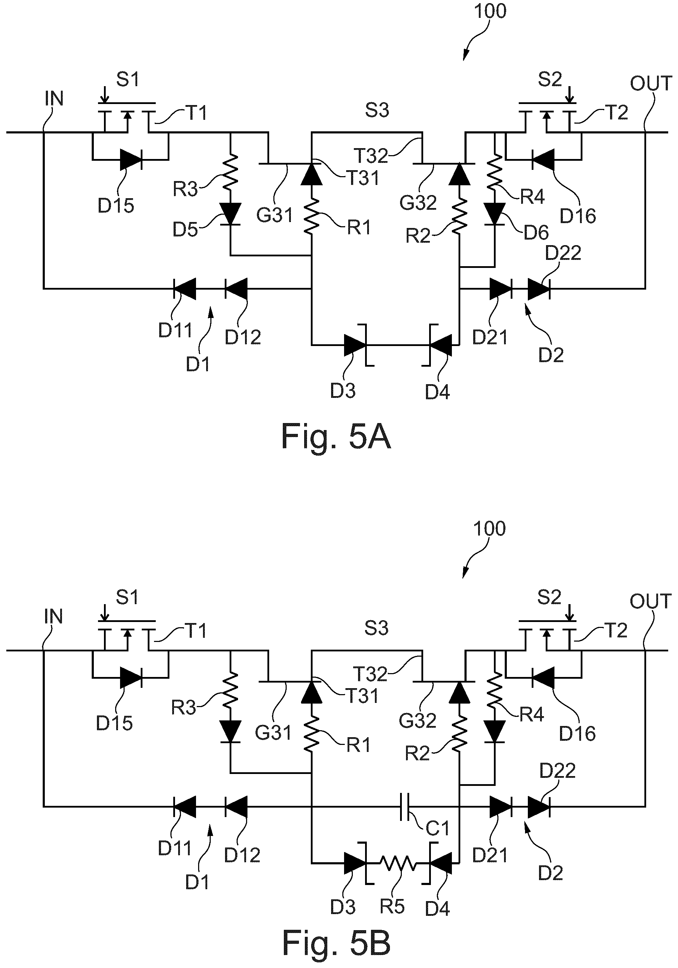

FIG. 5A depicts a further embodiment of a bidirectional switching assembly 100 which comprises a first switching unit S1, a second switching unit S2 and a third switching unit S3 sandwiched between the other switching units S1, S2. The main difference with respect to the embodiment of FIG. 1 lies in that the third switching unit S3 comprises two JFET semiconductor switches T31, T32 connected in series, thereby increasing the blocking voltage. The first and second switching units S1, S2 are built in the same manner as in FIG. 1.

The two JFETs T31, T32 each comprise a gate G31, G32, wherein the Gates G31, G32 are connected through high-voltage diode D1 with the input side IN and gates G31, G32 are connected through high-voltage diode D2 with the output OUT. In this respect, it is pointed out that the high-voltage diodes D1, D2 may comprise several high-voltage diodes arranged in series, such as diodes D11, D12 and D21, D22 as shown in FIG. 5A. The diodes D1, D2 serve the same function as in FIG. 1, namely, the blocking of high voltage.

The switching assembly of FIG. 5A further comprises a balancing circuit to consider the presence of two JFETs T31, T32, wherein the balancing circuit provides for equal sharing of the blocking voltage between the two JFETs and also makes sure that both JFETs are switched on and off at the same time. The balancing circuit comprises two avalanche diodes D3, D4 connected to back to back, wherein the gates G31, G32 of JFETs T31, T32 are connected through the avalanche diodes D3, D4. As the two avalanche diodes D3, D4 are connected back to back, one will be conducting and other will be blocking based on the current directions.

The balancing circuit further comprises low-voltage diodes D5, D6. Diode D5 has a terminal connected to a point between the first and third semiconductor switches S1, S3 and a terminal connected to the gate G31 of T31. Diode D6 has a terminal connected to a point between the third and second semiconductor switches S3, S2 and a terminal connected to the gate G32 of T32. The diodes D5 and D6 are low voltage (less than 50V) and low current rated. Further, a plurality of resistors R1 to R4 are provided. The avalanche diodes D3, D4, the additional diodes D5, D6 and the resistors R1 to R4 are used for the balancing voltage across the JFETs T31, T32.

The switching assembly 100 may be realized monolithically or as a power module connecting discrete MOSFET, JFET and diode components in a substrate. The low Voltage MOSFETs T1, T2 are high current capable. They may be configured to have a maximum drain-to-source voltage of 40 Volts and to have a 500 Ampere maximum current through the drain-source channel. The resistance of the drain-source channel in the ON state of the MOSFETs T1, T2 may be in the range of 0.5 mΩ (milliohm). The high-voltage JFETs T31, T32 may be configured to block a voltage of 1200 V, such that they put together a block a voltage of 2400 V. They may have a maximum current through the drain-source channel of 120 Ampere.

It is pointed out that in case of higher current requirements several JFETs and also several MOSFETs may be connected in parallel. This also applies to the embodiment of FIG. 1.

The JFET semiconductor switches T31, T32 may be SiC JFETs. In another embodiment, T31, T32 are HEMT semiconductor switches such as GaN HEMT.

FIG. 5B shows a switching assembly 100 which is modified with respect to the switching assembly of FIG. 5A in that additionally a slew rate control is implemented by adding a resistor R5 between the avalanche diodes D3, D4 and by having a capacitor C1 between diodes D1, D2, wherein the capacitor C1 and the resistor R5 form a filtering circuit that limits the rate of change of the gate signal. The capacitor C1 may be in pF range and the resistor R5 in the kΩ range, wherein the current flowing through the capacitor C1 and the resistor R5 will be very small.

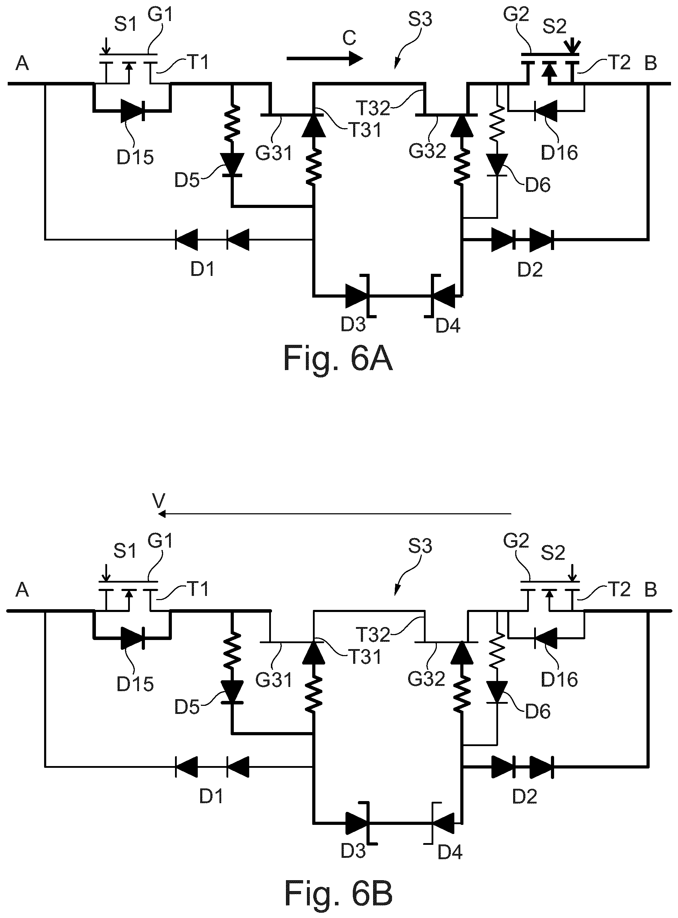

The function of the switching assemblies of FIGS. 5A, 5B will next be discussed in more detail with reference to FIGS. 6A to 6D.

According to FIG. 6A, the situation is considered that a current is flowing from point A to point B. For example, point A is connected to a positive DC terminal and point B is connected to a load. If the current is flowing from A to B, the antiparallel diode D15 of the first switching unit S1 will conduct and a current will pass through JFETs T31, T32 and then through MOSFET T2 if MOSFET T2 is in ON state. To this end, a turn ON voltage from a gate driver is applied to the gate G2 of MOSFET T2. During this time, blocking high-voltage diode D1 will be reverse biased, while high-voltage diode D2 will be forward biased, wherein the JFET T31, T32 conduction is based on the voltage drop across MOSFET T2.

In an embodiment, MOSFET T1 is also turned ON, wherein MOSFET T1 will also conduct current and have lower losses.

FIG. 6B shows the situation that the switching unit S2 is switched/turned off (by the gate driver providing a corresponding control signal to the gate G2 of T2). In such case, the voltage drop across switching unit S2 will increase. Thereby the bias gate voltage at gates G31, G32 of JFETs T31, T32 will increase in the negative direction. This leads to JFETs T31, T32 becoming fully switched/turned off and JFETs T31, T32 starting to block the high voltage.

It is to be noted that high-voltage diode D1 in its blocking state prevents the gates G31, G32 to see a large positive voltage applied at A. This allows the JFETs to be put into the OFF state from both directions while protecting the JFETs gates. Once the JFETs T31, T32 are turned OFF, the full voltage across the JFETs T31, T32 and small voltages across the MOSFET T2 apply. The current flow is completely stopped.

The avalanche diodes D3, D4 balance the voltage across the JFETs T31, T32. In case of FIG. 5B with a resistance R5 and a capacitor C1 provide control of the slew rate.

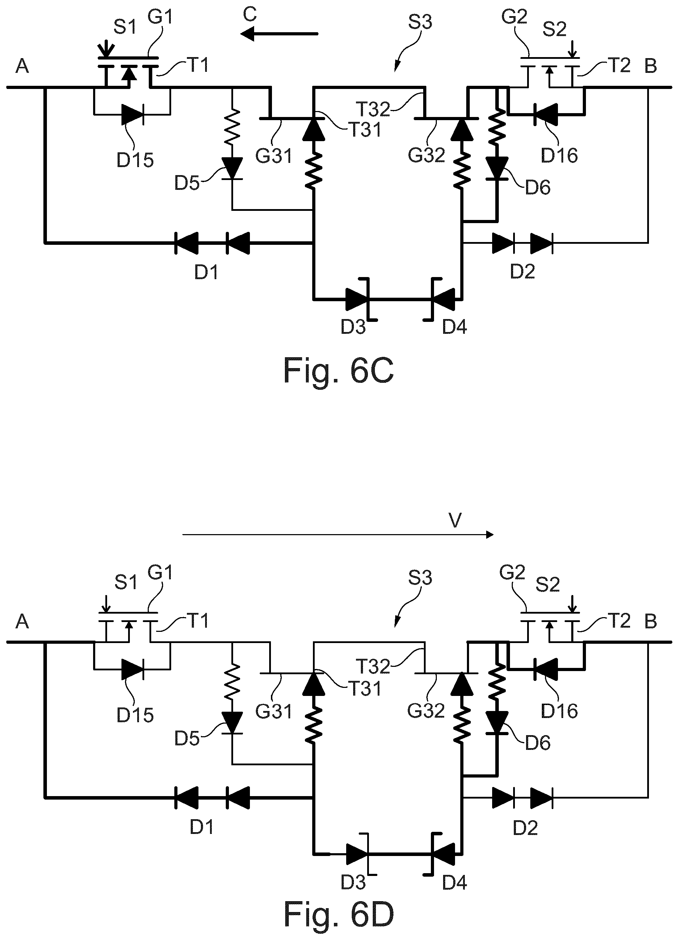

FIG. 6C considers the situation of a reverse current flow, wherein a current is flowing from point B to point A. If the current is flowing from B to A, the antiparallel diode D16 of the second switching unit S2 will conduct and a current will pass through JFETs T32, T31 and then through MOSFET T1 if MOSFET T1 is in ON state. To this end, a turn ON voltage from a gate driver is applied to the gate G1 of MOSFET T1. During this time, blocking high-voltage diode D2 will be reverse biased, while high-voltage diode D1 will be forward biased, wherein the JFETs T31, T32 conduction is based on the voltage drop across MOSFET T1.

FIG. 6D shows the situation that the switching unit S1 is switched/turned off (by a gate driver providing a corresponding control signal to the gate G1 of T1). In such case, the voltage drop across switching unit S1 will increase. At the same time, a positive voltage is maintained at B. Accordingly, the voltage drop across S1 will increase, thereby the gate voltage at gates G31, G32 of JFETs T31, 32 (bias voltage) will increase. This leads to JFETs T31, T32 becoming fully switched/turned off and JFETs T31, T32 starting to block the high voltage.

The same logical pulse may be provided to gates G1, G2 of MOSFETs T1, T2 irrespective of the voltage or current direction.

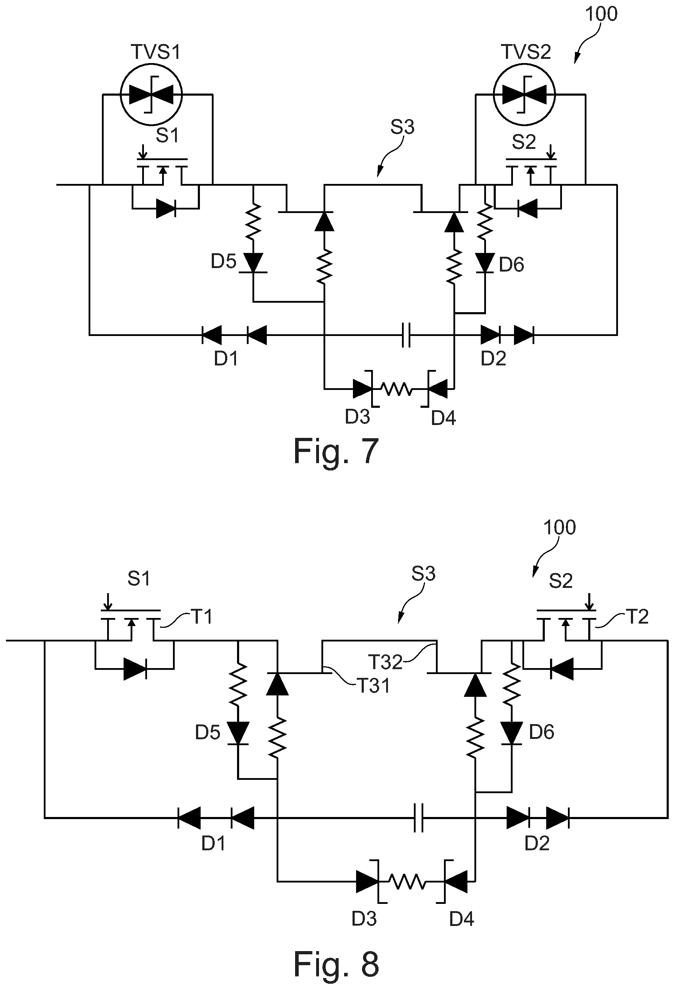

FIG. 7 shows an embodiment of a bidirectional switching assembly 100 which is similar to the switching assembly of FIG. 5B except that additionally transient voltage suppressor diodes TVS1, TVS2 are arranged in parallel to the MOSFETs T1, T2 for over voltage protection. Thereby, during the off state, the voltage across the MOSFETs T1, T2 will be low voltage (the TVS voltage) and the full blocking voltage appears across the JFETs T31, T32.

FIG. 8 shows an embodiment of a bidirectional switching assembly 100 which is similar to the switching assembly of FIG. 5B except that the cascoded JFETs T31, T32 are connected back-to-back in common drain configuration, as indicated by the position of the gate arrow in JFETs T31, T32. In such a configuration, the requirement of low-voltage MOSFETs can be eliminated by using the MOSFETs in the cascoded JFET. Thereby, it is possible to further reduce the footprint and loss in the system.

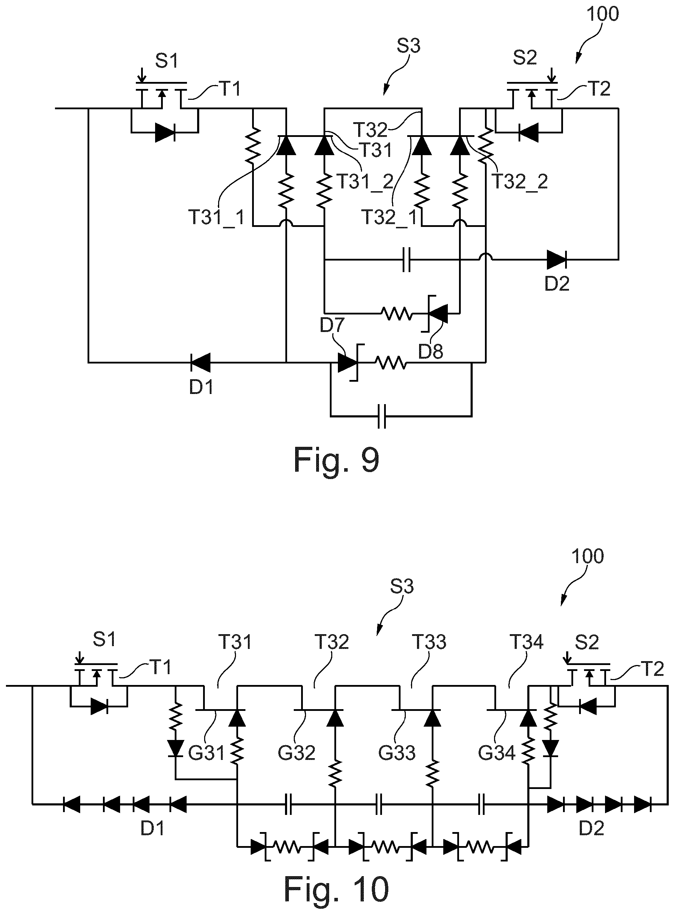

FIG. 9 shows an embodiment of a bidirectional switching assembly 100 which is similar to the switching assembly of FIG. 5B except that JFETs T31, T32 with a dual gate configuration are implemented. Accordingly, JFET T31 comprises a first gate G31_1 and a second gate G31_2, and JFET T32 comprises a first gate G32_1 and a second gate G32_2. Both gates are able to control the current flow between drain and source of the respective JFET. In this embodiment, high-voltage diode D1 is connected with one of its terminals to the gates G31_1, G32_1. High Voltage diode D2 is connected with one of its terminals to the gates G31_2, G32_2. The high voltage blocking diodes D1, D2 protect the respective gate voltage. Additional diodes D7, D8 are provided between G31_1, G32_1 and G31_2, G32_2, respectively. The embodiment of FIG. 9 increases the blocking capability of the switching assembly on both directions.

FIG. 10 is an example embodiment of a bidirectional switching assembly in which the third switching unit S3 comprises four JFETs (or HEMTs) arranged in series between the first switching unit S1 and the second switching unit S3. The third switching unit S3 thus comprises four JFETs T31-T34. The gates of two respective JFET are connected in each case through two avalanche diodes connected back-to-back, similar as in FIGS. 5A, 5B.

In other embodiments, the bidirectional switching assembly 100 may comprise a third switching unit S3 with another number of JFETs or HEMTs, such as three, five or six.

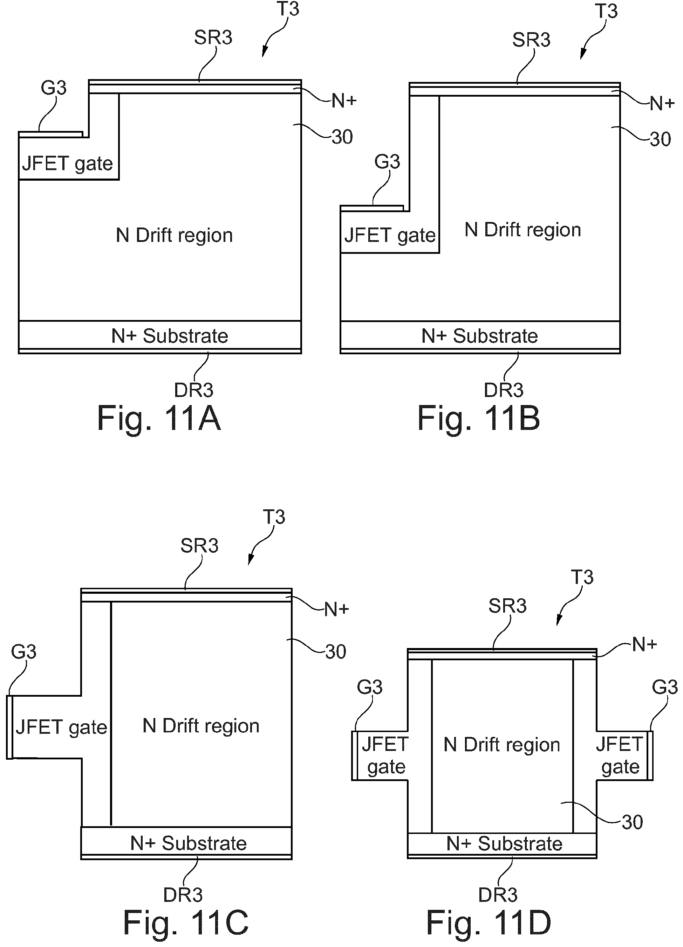

FIGS. 11A to 11E regard different embodiments of a JPEG semiconductor switch T3. Ideally, a JFET's source and drain terminals are identical, and the doping of carriers is nearly equal. However, conventional JFETs struggle to fully block voltage in both directions, especially in high voltage applications. In high voltage JFETs, the reverse blocking voltage (V_{SD}) is lower than the forward blocking voltage (V_{DS}) due to the proximity of the gate terminal to the source. To address these such challenges, the gate terminal of the JFET is shifted to the middle of the structure, as is illustrated in FIGS. 11A to 11E. FIG. 11A depicts the conventional JFET structure, while FIGS. 11B, 11C and 11D illustrate the improved structure designed to effectively block rated voltage on both sides in different modifications. As shown in the Figures, the JPEG T3 comprises a drift region 30 that is arranged between a source terminal SR3 and a drain terminal DR3 of the switch T3. The gate terminal G3 is arranged in the middle of the drift region 30, at even space to the source terminal SR3 and the drain terminal DR3.

In FIG. 11D, the gate G3 forms two sides (or the gate may be made as circle type) to get the effective blocking features.

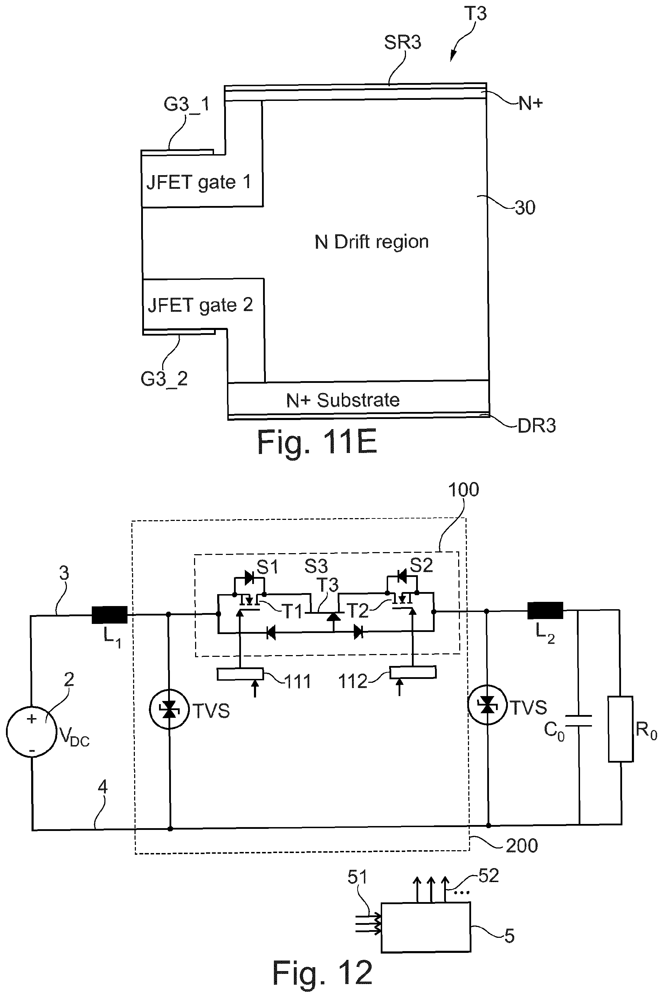

FIG. 11E shows a dual gate topology JFET that can be used for blocking in both directions. JFET T3 comprises first and second gate terminals G3_1, G3_2 which are arranged symmetrically with respect to the source terminal SR3 and the drain terminal DR3. Gate terminal G3_1 is located closer to the source terminal SR3. Gate terminal G3_2 is located closer to the drain terminal DR3.

Modifying the structure as indicated in FIGS. 11B to 11E may impact the switching loss of the system, but the proposed topology is recommended at least for Solid State Power Controllers (SSPCs), where switching loss is not a critical concern for the system.

The bidirectional switching assembly of the present invention may be implemented in any device which requires bidirectional switching. In embodiments, the bidirectional switching assembly may be implemented in a solid state power controller (SSPC), a matrix converter, a T-Type converter, a Vienna rectifier, or a battery charging circuit.

FIGS. 12 to 27 provide examples of how the bidirectional switching assembly may be implemented in a circuit/system, without these examples limiting the application of the switching assembly.

FIG. 12 depicts a power system which is similar to the power system of FIG. 28. The power system comprises a power bus with a positive voltage rail 3 connected to the positive terminal of a DC power source 2 and with a negative voltage rail 4 connected to the negative terminal of the DC power source 2. The power bus 3, 4 serves to connect a load R₀ to the power source 2. A load capacitor C₀ is arranged in parallel to the load R₀. Further, inductors L1, L2 may be provided. In this respect, reference is made to the description of FIG. 28.

An SSPC 200 is arranged in the positive voltage rail 3. The SSPC 200 comprises a bidirectional switching assembly 100 which is constructed in accordance with the embodiment of FIG. 1.

The SSPC 200 also comprises two gate drivers 111, 112 for the low-voltage MOSFETs T1, T2. It is pointed out that the gate drivers 111, 112 are depicted schematically only. In another embodiment, there may be provided a single gate driver for the two MOSFETs S2, S2. The SSPC 200 may further comprise a microcontroller (not shown) for logic control.

Further, a controller 5 is provided which is depicted schematically. The controller 5 is configured to receive information about the status of the circuit and the occurrence of a fault condition through input lines 51. Such information may be provided from the gate drivers 111, 112 or from sensor elements associated with the individual switches or other elements (such as thermal sensor or current sensor). For example, if a switch or other element is short-circuited, an error signal is received by controller 5 through input lines 51.

In case a fault condition is detected, the controller 5 is configured to control the SSPC 200 to break a current in the power system. To this end, control signals are sent through output lines 52 to the gate drivers 111, 112, wherein the gate drivers 111, 112 provide control signals to the gates G1, G2 such that the MOSFETs T1, T2 and thus the first and second switching units S1, S2 are switched off, this causing switching off of the high-voltage JFET ST in the manner discussed above.

The controller 5 may comprise a processor for executing instructions and a memory which is coupled to the processor and in which instructions are stored which, when executed by the processor, cause the processor to perform said functions of receiving information about semiconductor switches and other elements in providing control signals to the gate drives 111, 112. The controller 5 may be a separate unit or may be integrated into a gate driver or may be integrated into a microcontroller of the SSPC 200. Also, the controller 5 may communicate with other control devices of the system.

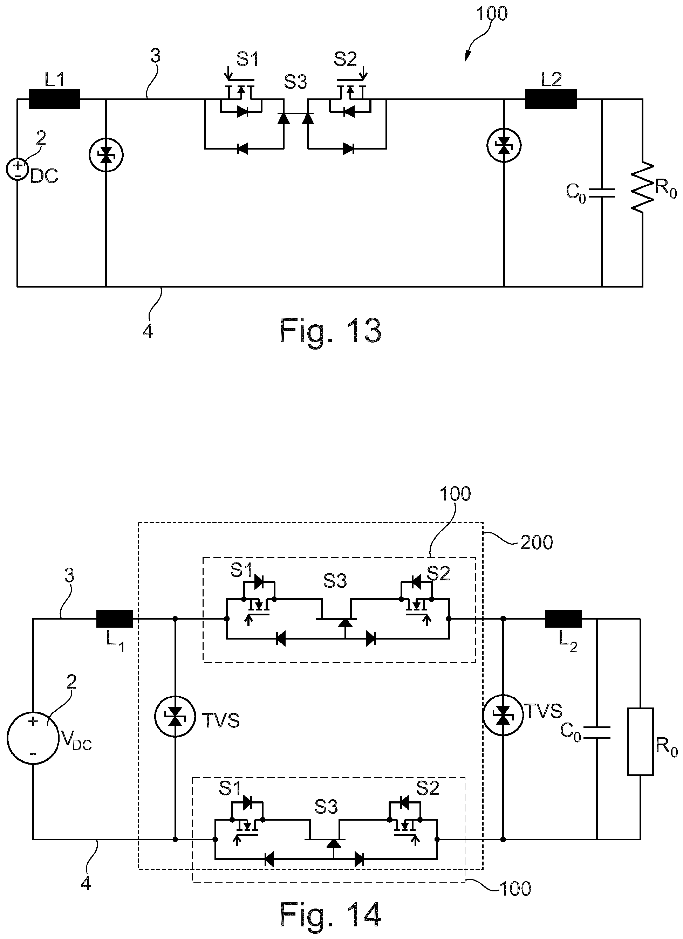

FIG. 13 shows an embodiment of a power system which is similar to the power system of FIG. 12 except that the SSPC comprises a bidirectional switching unit 100 in accordance with the dual gate embodiment of FIG. 4.

FIG. 14 shows an embodiment of a power system which is similar to the power system of FIG. 12 except that the SSPC comprises a bidirectional switching unit 100 in accordance with the embodiment of FIG. 1 both in the positive voltage rail 3 and the negative voltage rail 4.

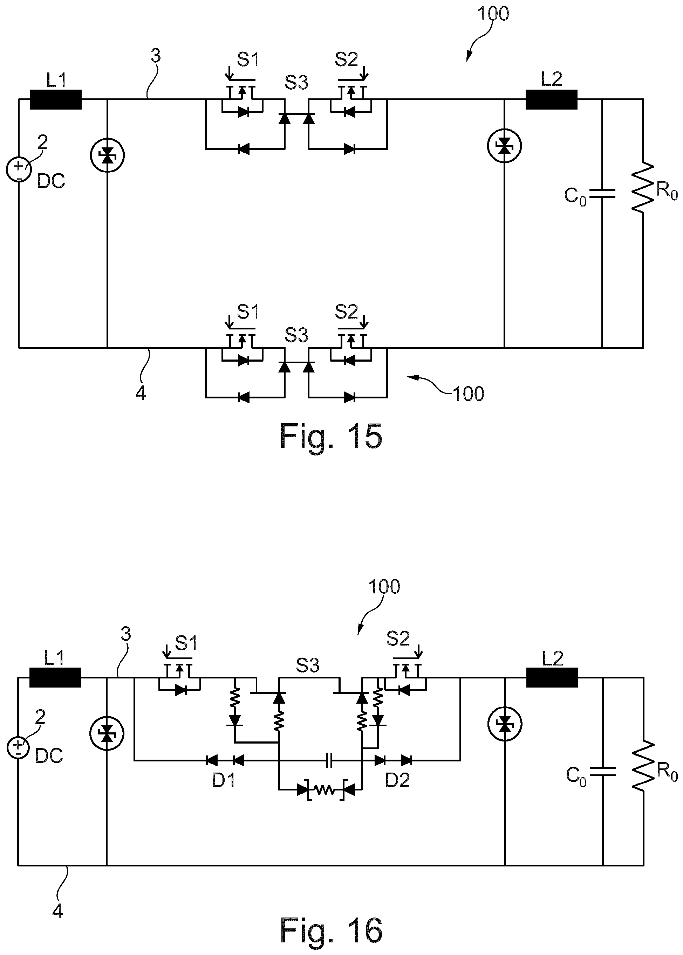

FIG. 15 shows an embodiment of a power system which is similar to the power system of FIG. 12 except that the SSPC comprises a bidirectional switching unit 100 in accordance with the dual gate embodiment of FIG. 4 both in the positive voltage rail 3 and the negative voltage rail 4.

FIG. 16 shows an embodiment of a power system which is similar to the power system of FIG. 12 except that the SSPC comprises a bidirectional switching unit 100 in accordance with the embodiment of FIG. 5B.

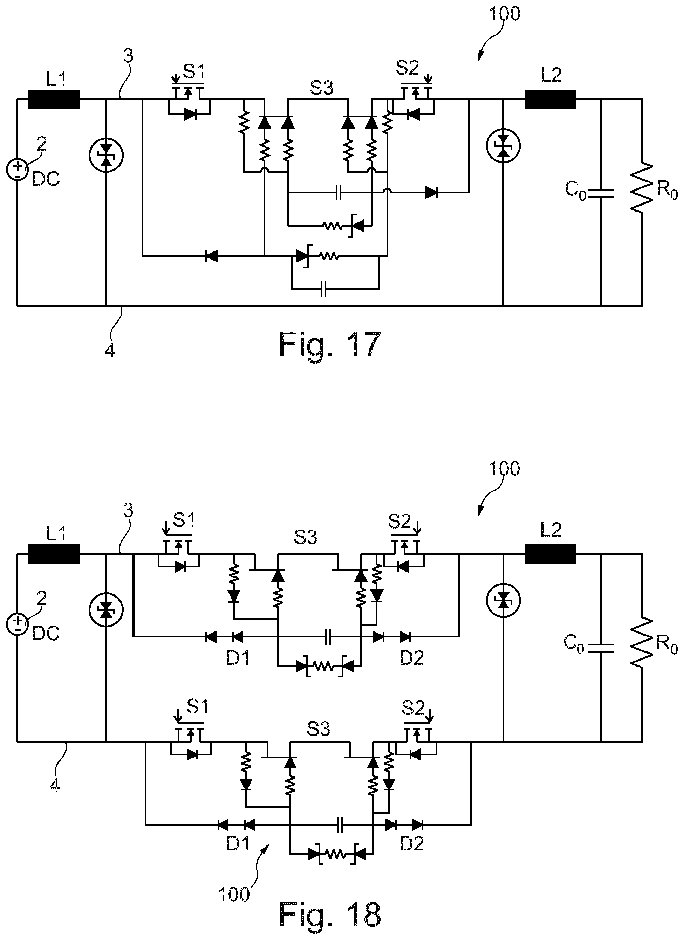

FIG. 17 shows an embodiment of a power system which is similar to the power system of FIG. 12 except that the SSPC comprises a bidirectional switching unit 100 in accordance with the embodiment of FIG. 9.

FIG. 18 shows an embodiment of a power system which is similar to the power system of FIG. 12 except that the SSPC comprises a bidirectional switching unit 100 in accordance with the embodiment of FIG. 5B both in the positive voltage rail 3 and the negative voltage rail 4.

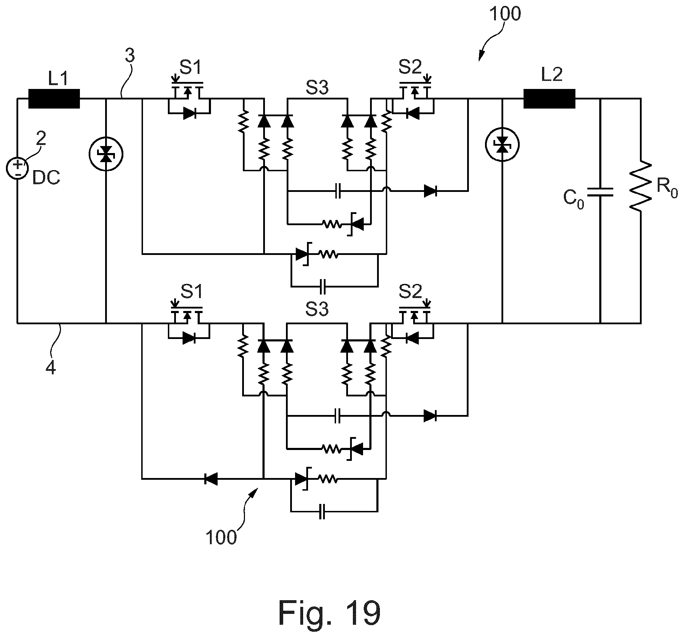

FIG. 19 shows an embodiment of a power system which is similar to the power system of FIG. 12 except that the SSPC comprises a bidirectional switching unit 100 in accordance with the dual gate embodiment of FIG. 9 both in the positive voltage rail 3 and the negative voltage rail 4.

A further application of bidirectional switching assemblies in accordance with the present invention are matrix converters. A matrix converter is a power converter that achieves direct AC/AC conversion without an intermediate energy storage, as well known to the skilled person. They are widely used in electrical distribution systems.

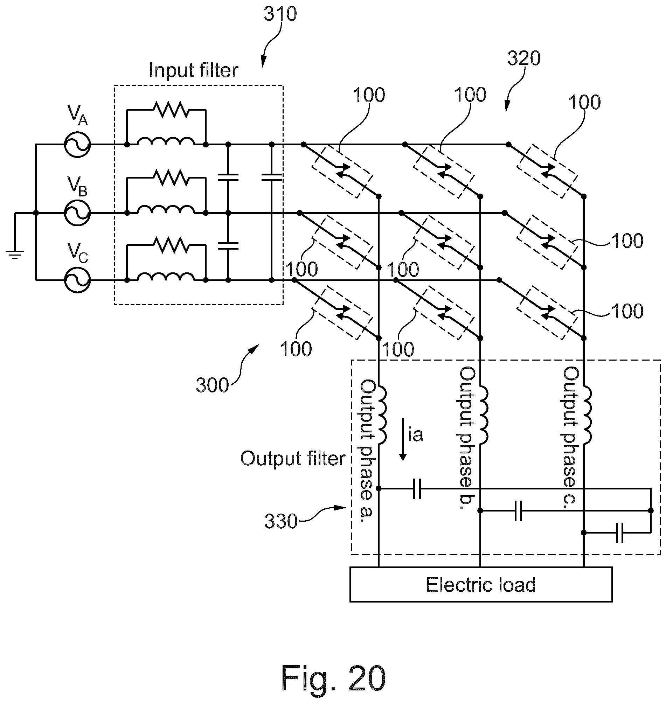

An example matrix converter that implements the present invention is depicted in FIG. 20. The matrix converter 300 comprises an AC input side 310 with an input filter, an AC output side 330 with an output filter, and an array 320 of bidirectional switching assemblies 100 arranged in between. The bidirectional switching assemblies 100 are of the kind discussed with respect to FIGS. 1 to 11, and any of the embodiments of FIGS. 1 to 11 may be implemented. The bidirectional switching assembly 100 are controlled to transfer power from each phase to a respective other phase using similar modulation techniques as known matrix converters.

With such matrix converters, the number of high-voltage switches is reduced compared to conventional matrix converters, and the use of the matrix converters becomes significantly more attractive.

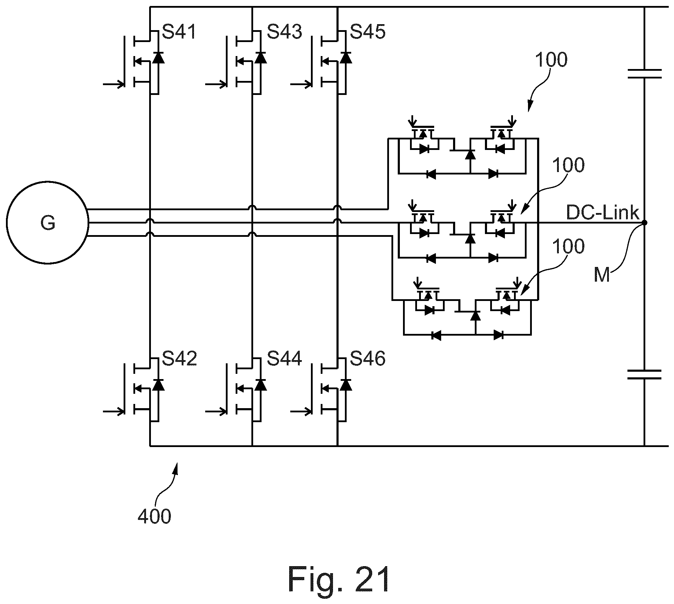

A further application of bidirectional switching assemblies in accordance with the present invention are T type converters, as depicted in FIG. 21. T-type converters are widely used for power factor correction and high-power application in a distribution system. A T-type converter uses bidirectional switches in a neutral Midpoint M of DC-Link capacitors as shown in the FIG. 21. These bidirectional switches can be implemented by bidirectional switching assemblies in accordance with the present invention, such as described with respect to FIGS. 1 to 11.

In a similar manner, bidirectional switching assemblies in accordance with the present invention can be implemented in Vienna rectifiers which combine a three-phase diode bridge with an integrated boost converter. In a Vienna rectifier, a midpoint M of DC-Link capacitors is connected through bidirectional switching assemblies 100 in accordance with the present invention, such as described with respect to FIGS. 1 to 11.

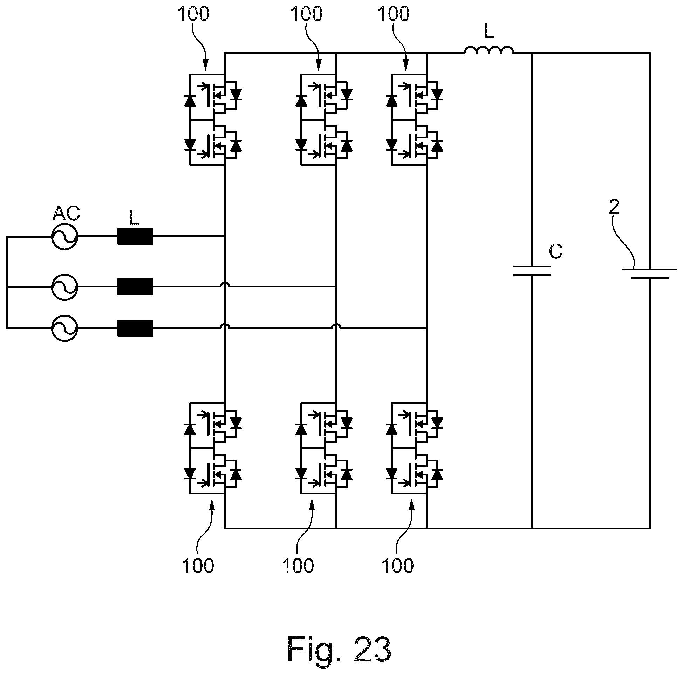

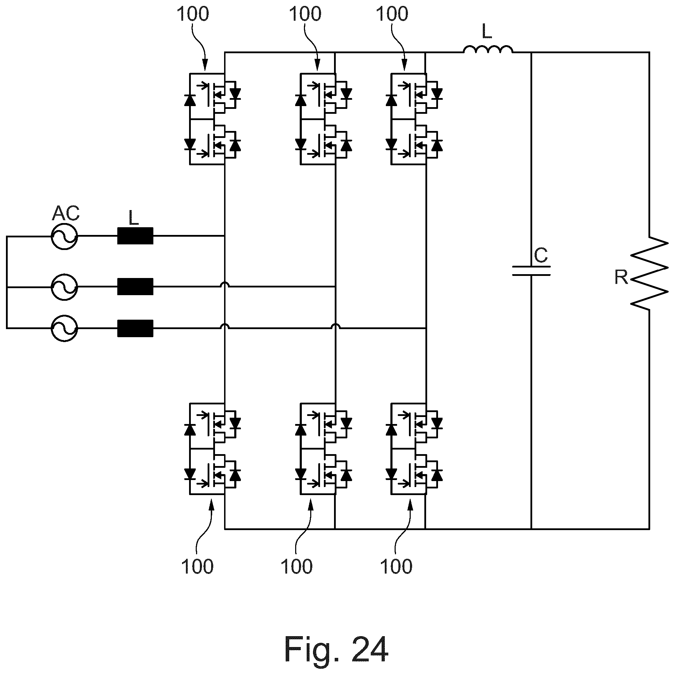

A still further application of bidirectional switching assemblies in accordance with the present invention are battery charging circuits for electro vehicle (EV) applications. FIG. 23 shows a charging circuit which implements a bidirectional switch based converter. Bidirectional switching assemblies 100 in accordance with the present invention are implemented in a three-phase single stage charging topology that charges a battery 2. Thereby, the loss and the footprint of the converter can be reduced. Alternatively, as shown in FIG. 24, the charging topology is used for a DC load R.

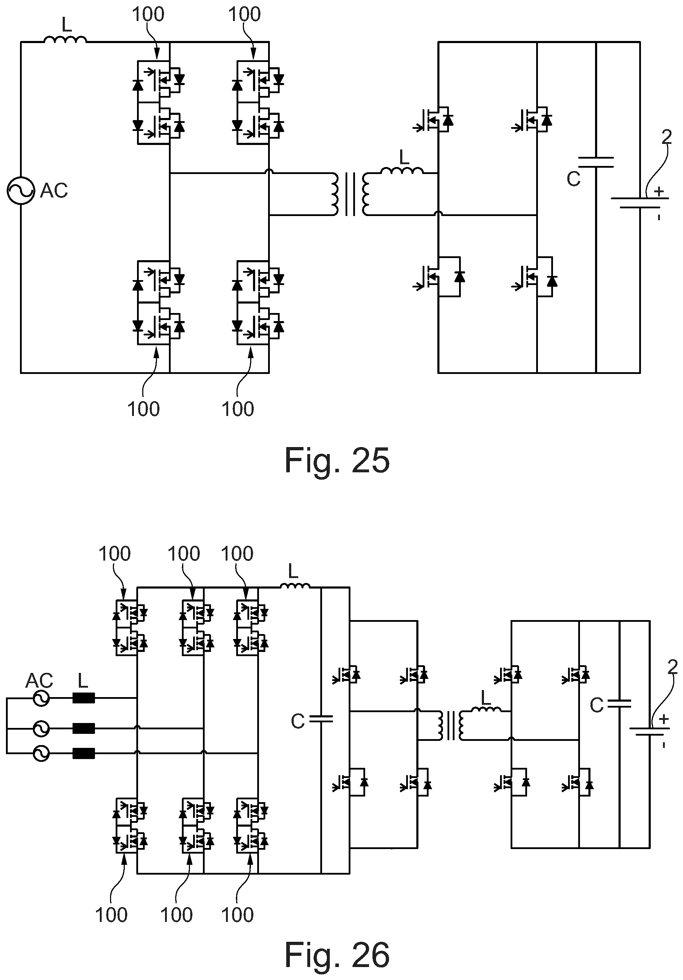

A still further application of bidirectional switching assemblies in accordance with the present invention are isolated charging circuits, as depicted in FIG. 25, wherein bidirectional switching assemblies in accordance with the present invention are implemented instead of conventional bidirectional circuits. FIG. 26 depicts a three-phase charging circuit for EV applications. FIG. 27 depicts a three-phase charging circuit with LC resonance. In each of these a charging circuits, bidirectional switching assemblies 100 in accordance with the present invention are implemented, such as described with respect to FIGS. 1 to 11.

It should be understood that the above description is intended for illustrative purposes only, and is not intended to limit the scope of the present disclosure in any way. Also, those skilled in the art will appreciate that other aspects of the disclosure can be obtained from a study of the drawings, the disclosure and the appended claims. All methods described herein can be performed in any suitable order unless otherwise indicated herein or otherwise clearly contradicted by context. Various features of the various embodiments disclosed herein can be combined in different combinations to create new embodiments within the scope of the present disclosure. In particular, the disclosure extends to and includes all combinations and subcombinations of one or more features described herein. Any ranges given herein include any and all specific values within the range and any and all sub-ranges within the given range.

## Claims

1. A bidirectional switching assembly (100) comprising:
a first switching unit (S1) which comprises a first low voltage MOSFET (T1), wherein the first low voltage MOSFET (T1) comprises a first gate (G1);
a second switching unit (S2) which comprises a second low voltage MOSFET (T2), wherein the second low voltage MOSFET (T2) comprises a second gate (G2);
a third switching unit (S3) which comprises a normally ON high voltage semiconductor switch (T3, T31, T32), wherein the normally ON high voltage semiconductor switch (T3, T31, T32) comprises a third gate (G3, G31, G32) and wherein the third gate (G3, G31, G32) is connected through high-voltage diodes (D1, D2) with an input side (IN) and with an output side (OUT) of the switching assembly (100);
wherein the first switching unit (S1), the third switching unit (S3) and the second switching unit (S2) are arranged in series, with the third switching unit (S3) sandwiched between the first switching unit (S1) and the second switching unit (S2);
wherein in one direction the third switching unit (S3) and the second switching unit (S2) form a cascode and in the other direction the third switching unit (S3) and the first switching unit (S1) form a cascode;
wherein the switching assembly (100) is configured to conduct a current in either direction when the third switching unit (S3) is switched on;
wherein the switching assembly (100) is configured to block a current in either direction when the third switching unit (S3) is switched off; and
wherein the third switching unit (S3) is switched on and off by switching on and off at least one of the first and second switching units (S1, S2).

2. The bidirectional switching assembly of claim 1, wherein the high-voltage diodes (D1, D2) comprise a first high-voltage diode (D1) connected at one terminal to the third gate (G3, G31, G32) and connected at the other terminal to the input side (IN) of the switching assembly, and a second high-voltage diode (D2) connected at one terminal to the third gate (G3, G31, G32) and connected at the other terminal to the output side (OUT) of the switching assembly.

3. The bidirectional switching assembly of claim 1 or 2, wherein the first switching unit (S1) and the second switching unit (S2) each comprise an antiparallel diode (D15, D16) arranged antiparallel to the first low voltage MOSFET (T1) and the second low voltage MOSFET (T2), respectively.

4. The bidirectional switching assembly of any preceding claim, wherein the first switching unit (S1) and the second switching unit (S2) each comprise a bidirectional transient voltage suppressor diode (TSV1, TSV2) arranged in parallel to the first low voltage MOSFET (T1) and the second low voltage MOSFET (T2), respectively.

5. The bidirectional switching assembly of any preceding claim, wherein the first low voltage MOSFET (T1) and the second low voltage MOSFET (T2) are controlled with the same logic signal.

6. The bidirectional switching assembly of any preceding claim, wherein the first low voltage MOSFET (T1) and the second low voltage MOSFET (T2) are driven by independent gate drivers (111, 112).

7. The bidirectional switching assembly of any preceding claim, wherein the switching assembly (100) is configured to conduct a current in the one direction when at least the third switching unit (S3) and the second switching unit (S2) are switched on, and further configured to conduct a current in the other direction when at least the third switching unit (S3) and the first switching unit (S1) are switched on, in particular wherein the switching assembly (100) is configured to change from a first state in which a current is guided in the one direction to a second state in which a current in either direction is blocked in that in the first state the second low voltage MOSFET (T2) is configured to be switched on and in the second state the second low voltage MOSFET (T2) is configured to be switched off.

8. The bidirectional switching assembly of any preceding claim, wherein the first low voltage MOSFET (T1) and the second low voltage MOSFET (T2) are configured to have a maximum drain-to-source voltage of 40 Volts and/or to have a 500 Ampere maximum current through the drain-source channel.

9. The bidirectional switching assembly of any preceding claim, wherein the normally ON high voltage semiconductor switch (T3) comprises a dual gate configuration with a first third gate (G3_1) and a second third gate (G3_2), wherein the first third gate (G3_1) is connected through a high-voltage diode (D1) with the input side (IN) of the switching assembly and the second third gate (G3_2) is connected through a high-voltage diode (D2) with the output side of the switching assembly.

10. The bidirectional switching assembly of any preceding claim, wherein the third semiconductor switch (S3) comprises first and second normally ON high voltage semiconductor switches (T31, T32) arranged in series and both sandwiched between the first and second semiconductor switches (S1, S2), wherein the gates (G31, G32) of the first and second normally ON high voltage semiconductor switches (T31, T32) are each connected through at least one high-voltage diode (D1, D2) with an input side (IN) and with an output side (OUT) of the switching assembly (100).

11. The bidirectional switching assembly of claim 10, wherein the assembly (100) further comprises a balancing circuit for balancing the voltage across the first and second normally ON high voltage semiconductor switches (T31, T32), wherein the balancing circuit comprises two avalanche diodes (D3, D4; D7, D8), the avalanche diodes (D3, D4) connecting the gates (G31, G32) of the first and second normally ON high voltage semiconductor switches (T31, T32), in particular wherein the balancing circuit further comprises a low-voltage diode (D5) having a terminal connected to a point between the first and third semiconductor switches (S1, S3) and a terminal connected to the gate (G31) of the first normally ON high voltage semiconductor switch (T31), and a low-voltage diode (D6) having a terminal connected to a point between the third and second semiconductor switches (S3, S2) and a terminal connected to the gate (G32) of the second normally ON high voltage semiconductor switch (T32).

12. The bidirectional switching assembly of any preceding claim, wherein the normally ON high voltage semiconductor switch (T3) comprises a drift region (30) arranged between a source terminal (SR3) and a drain terminal (DR3) of the semiconductor switch (T3), wherein the gate terminal (G3) is arranged in the middle of the drift region (30), at even space to the source terminal (SR3) and the drain terminal (DR3), wherein in particular, when dependent on claim 9, the normally ON high voltage semiconductor switch (3) comprises first and second gate terminals (G3_1, G3_2), wherein the first and second gate terminals (G3_1, G3_2) are arranged symmetrically with respect to the source terminal (SR3) and the drain terminal (DR3).

13. The bidirectional switching assembly of any preceding claim, wherein the normally ON high voltage semiconductor switch (T3, T31, T32) is a JFET or HEMT semiconductor switch, and/or wherein the switching assembly (100) is an element of a solid state power controller, a matrix converter, a T-Type converter, a Vienna rectifier, or a battery charging circuit.

14. A power system comprising:
a power bus (3, 4) comprising a positive voltage rail (3) and a negative voltage rail (4) and configured to connect a power source (2) with a load (R); and
a bidirectional solid state power controller (200) arranged in at least one of the positive voltage rail (3) and the negative voltage rail (4);
wherein the bidirectional solid state power controller (200) comprises a bidirectional switching assembly (100) of any one of claims 1 to 13;
in particular further comprising a controller (5), wherein the controller (5) is configured to receive information or determine that there is a fault, wherein, in such case, the controller (5) is further configured to control the first and second switching units (S1, S2) of the bidirectional switching assembly (100) such that these are switched off.

15. A matrix converter (300) comprising:
an AC input side (310);
an AC output side (330); and
an array (220) of bidirectional switching assemblies (100) of any one of claims 1 to 13 and arranged between the AC input side (310) and the AC output side (330).
